(19) Europäisches Patentamt
European Patent Office
Office européen des brevets

(11) EP 4 124 909 A1

(12) EUROPEAN PATENT APPLICATION

(43) Date of publication:
01.02.2023 Bulletin 2023/05

(51) International Patent Classification (IPC):
G03F 7/20 (2006.01)        G01N 21/95 (2006.01)
G02B 21/10 (2006.01)        G03H 1/08 (2006.01)

(21) Application number: 21188279.0

(22) Date of filing: 28.07.2021

(52) Cooperative Patent Classification (CPC):
G03F 7/70625; G01N 21/95; G02B 21/10;
G03F 7/70633; G03H 1/0866

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventor: TARABRIN, Sergey
5500AH Veldhoven (NL)

(74) Representative: ASML Netherlands B.V.
Corporate Intellectual Property
P.O. Box 324
5500 AH Veldhoven (NL)

(54) METROLOGY METHOD AND DEVICE

(57) Disclosed is a dark-field interferometric microscope and associated microscopy method. The microscope comprises an object branch (OIB) being operable to propagate object radiation onto a sample (W) and collect resultant scattered radiation from said sample and a reference branch (RIB) being operable to propagate reference radiation. The object radiation and said reference radiation are mutually pointwise spatially coherent. A filter arrangement removes a zeroth order component from said scattered radiation to provide filtered scattered radiation; and a detection arrangement detects an interferometric image from interference of said filtered scattered radiation and reference radiation.

Fig. 6

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

Holographic metrology tools are known which enable phase information to be extracted from a holographic image. International patent application WO2019197117A1, incorporated herein by reference, discloses a method and metrology apparatus based on a dark field digital holographic microscope (df-DHM) to determine a characteristic, e.g., overlay, of a structure manufactured on a substrate. It would be desirable to improve on such holographic metrology tools.

SUMMARY

Embodiments of the invention are disclosed in the claims and in the detailed description.

In a first aspect of the invention there is provided a dark-field interferometric microscope comprising: an object branch being operable to propagate object radiation onto a sample and collect resultant scattered radiation from said sample; a reference branch being operable to propagate reference radiation; a filter arrangement operable to remove a zeroth order component from said scattered radiation to provide filtered scattered radiation; and a detection arrangement operable to detect an interferometric image from interference of said filtered scattered radiation and reference radiation; wherein said object radiation and said reference radiation are mutually pointwise spatially coherent.

In a second aspect of the invention there is provided a method of performing dark-field interferometric microscopy comprising: propagating object radiation onto a sample and collect resultant scattered radiation from said sample; removing a zeroth order component from said scattered radiation to provide filtered scattered radiation; propagating reference radiation; detecting an interferometric image from interference of said filtered scattered radiation and reference radiation; wherein said object radiation and said reference radiation are mutually pointwise spatially coherent.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 comprises a schematic diagram of an incoherent dark-field interferometric microscope according to embodiments of the invention;
- Figure 7 is a flow diagram illustrating pupil space diagrams at different planes within a device such as illustrated in Figure 6;
- Figure 8(a) is a schematic illustration of a wedge component usable in the device illustrated in Figure 6 with a first object and reference wavefront configuration thereon according to an embodiment; and (b) a resultant captured image;
- Figure 9 is a schematic illustration of a wedge component usable in the device illustrated in Figure 6 with a second object and reference wavefront configuration thereon according to an embodiment; and
- Figure 10 depicts a block diagram of a computer system for controlling a system and/or method as disclosed herein.

## DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

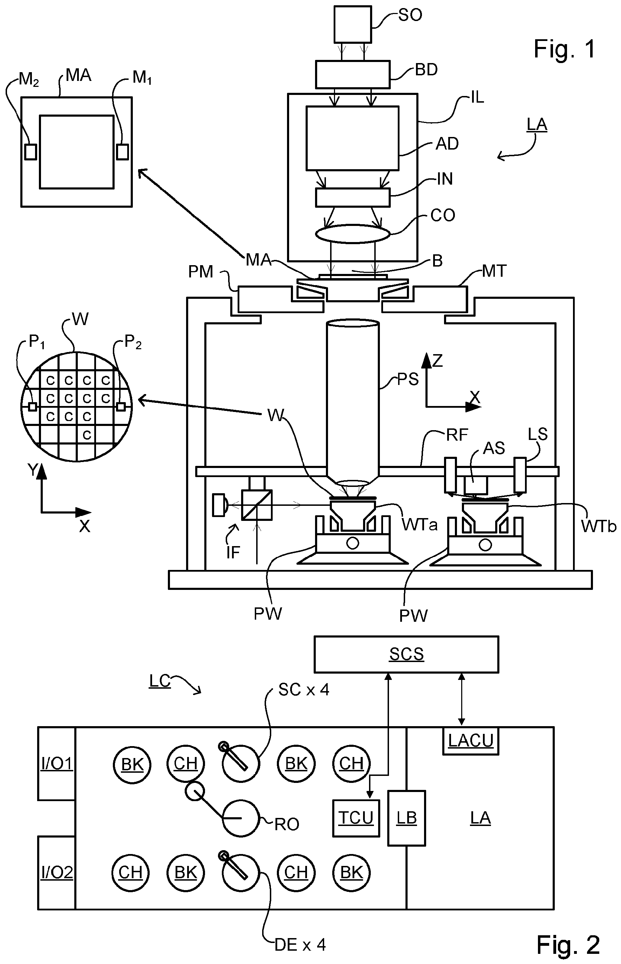

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform preand post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

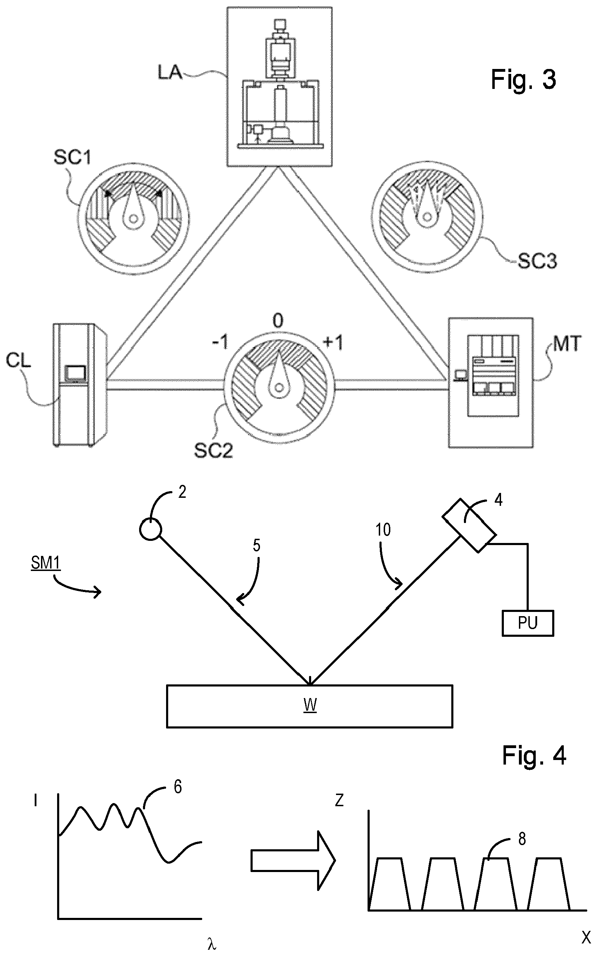

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

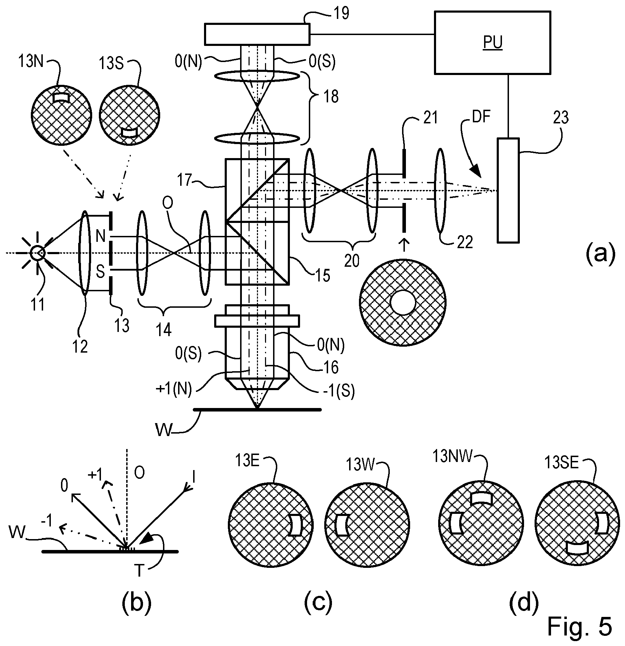

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a backprojected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

The metrology tool just described requires low aberrations (for good machine-to-machine matching for example) and a large wavelength range (to support a large application range for example). Machine-to-machine matching depends (at least partly) on aberration variation of the (microscope) objective lenses being sufficiently small, a requirement that is challenging and not always met. This also implies that it is essentially not possible to enlarge the wavelength range without worsening the optical aberrations. Furthermore, the cost of goods, the volume and/or the mass of a tool is substantial, limiting the possibility of increasing the wafer sampling density (more points per wafer, more wafers per lot) by means of parallelization by providing multiple sensors to measure the same wafer simultaneously.

To address at least some of these issues, a metrology apparatus which employs a computational imaging/phase retrieval approach has been described in US patent publication US2019/0107781, which is incorporated herein by reference. Such a metrology device may use relatively simple sensor optics with unexceptional or even relatively mediocre aberration performance. As such, the sensor optics may be allowed to have aberrations, and therefore produce a relatively aberrated image. Of course, simply allowing larger aberrations within the sensor optics will have an unacceptable impact on the image quality unless something is done to compensate for the effect of these optical aberrations. Therefore, computational imaging techniques are used to compensate for the negative effect of relaxation on aberration performance within the sensor optics.

A known type of metrology which may be used *inter alia* in lithography control and monitoring applications is digital holographic microscopy, in particular dark field digital holographic microscopy. Digital holographic microscopy is an imaging technology that combines holography with microscopy. Different from other microscopy methods that record projected images of an object, digital holographic microscopy records holograms formed by interference between object radiation obtained by irradiation of a three-dimensional (3D) object with reference radiation that is coherent with the object radiation. Images may be captured using, for example a charge coupled device (CCD) or a complementary metal oxide semiconductor (CMOS). Since the object radiation is radiation scattered from the object, wave-front of the object radiation is therefore modulated or shaped by the object. Said scattered radiation may comprise reflected radiation, diffracted radiation, or transmitted radiation. Therefore, the wavefront of the object radiation carries information of the irradiated object, e.g., 3D shape information. Based on the captured images of holograms, images of the object can be numerically reconstructed by using a computer reconstruction algorithm. An important advantage of hologram based metrology over intensity based metrology, is that hologram based metrology allows both intensity and phase information of an object to be obtained, without the need for the computationally intensive phase retrieval techniques described in the aforementioned US2019/0107781. With additional phase information, characteristics of the object can be determined with better accuracy.

The international patent application WO2019197117A1, incorporated herein by reference, discloses a method and metrology apparatus based on a dark field digital holographic microscope (df-DHM) to determine a characteristic, e.g., overlay, of a structure manufactured on a substrate. The df-DHM in described therein comprises a reference optical unit which is used to provide two reference radiation beams (the reference radiation). The two reference radiation beams may be respectively paired with two corresponding portions of object radiation (e.g., scattered radiation beams from a target), such as a +1 diffraction order and a -1 diffraction order. The two scattered-reference beam pairs are used sequentially to form two interference patterns (i.e., one corresponding to the +1 diffraction order and the other corresponding to the -1 diffraction order).

Such a df-DHM requires coherent radiation and coherence control is provided by way of adjusting the relative optical path-length difference (OPD) between the two scattered-reference beams within each beam pair.

There are disadvantages in using coherent radiation. The optical crosstalk performance is severely impacted by the fact that the coherent point spread function is substantial larger than an incoherent (or partially incoherent) point spread function. Such crosstalk may be from neighboring structures (e.g., product structures or other target or target pads) to the target being measured. This limits the process variation performance. Also of note is that for a given identical detection NA, the incoherent resolution (limit) is twice as good as the coherent resolution (limit), which is (from a different but related viewpoint) also beneficial to reduce optical crosstalk. Additionally, speckles (or stray light) are always present in coherent imaging due to imperfections and/or contamination of the optical components used.

To address these issues, it is proposed to use a spatial incoherent or a close approximation (or at least multimode) illumination for interferometric (holographic) microscopy. For the remaining description, the term incoherent illumination will be used to describe spatially incoherent illumination or a close approximation thereof.

Incoherent Holography as a microscopy technique is known. Such arrangements may comprise, for example, optical scanning holography and Fresnel incoherent correlation holography. However, there are drawbacks with these systems. In particular, these systems do not provide the advantages of dark-field microscopy, such as provided by a metrology tool such as illustrated in Figure 5(a) or described in WO2019197117A1.

As such, disclosed herein is a dark-field interferometric (holographic) microscope. Such a device will provide at least one pair of radiation beams comprising an object beam (as scattered from an object, e.g., a structure or target on a substrate/wafer) and a reference beam, where each beam is spatially incoherent, but where the beams have mutual pointwise coherence.

Pointwise coherence in this context describes an arrangement where spatial coherence is induced between corresponding sets of pupil points in each beam of an object beam-reference beam pair (hereafter beam pair). More specifically, each beam of a beam pair comprises corresponding pupil points having spatially coherence, but where the pupil points are incoherent within a single beam. As such, in terms of spatial coherence, each beam of a beam pair is a translation within the pupil of the other beam.

It should be appreciated that, in the context of this disclosure, a pupil point and pointwise coherence does not refer to a literal infinitely small point, but rather a finite small region within a pupil plane (i.e., a small but finite region of angles of an angular resolved spectrum in a pupil plane or Fourier plane). Of most relevant is that each beam of a beam pair has a phase profile with respect to the other beam which is a translation of the other beam within the pupil plane, such that corresponding points of each beam are coherent.

Disclosed is a dark-field interferometric microscope and associated microscopy method. The microscope comprises an object branch being operable to propagate object radiation (e.g., incoherent object radiation) onto a sample and collect resultant scattered radiation from said sample and a reference branch being operable to propagate reference radiation (e.g., incoherent reference radiation). The object radiation and said reference radiation are mutually pointwise spatially coherent. A filter arrangement removes a zeroth order component from said scattered radiation to provide filtered scattered radiation; and a detection arrangement detects an interferometric image from interference of said filtered scattered radiation and reference radiation.

One method for providing such a pair of incoherent beams which are mutually pointwise coherent may comprise, in an embodiment, splitting in a pupil plane, an incoherent radiation wavefront into two incoherent radiation wavefronts (e.g., which are identical copies). As such the wavefront from the radiation source may be split, in a pupil conjugate, into a reference branch and an object branch.

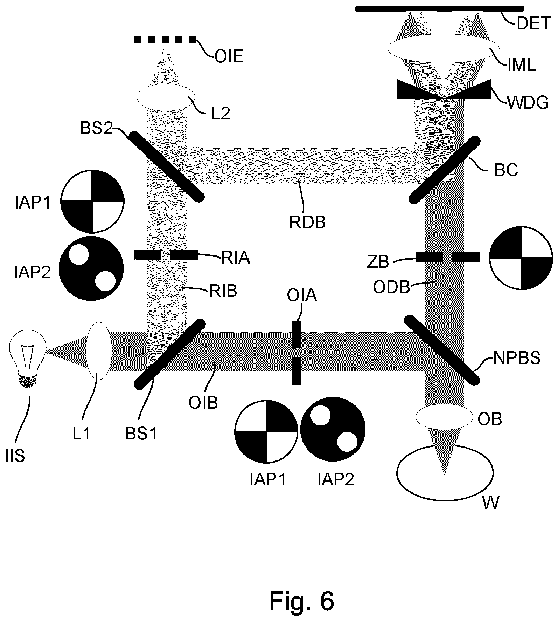

Figure 6 is a schematic diagram of an incoherent or partial-incoherent dark-field interferometric microscope according to an embodiment. An incoherent illumination source IIS provides incoherent illumination. A lens or lens system L1 provides access to a pupil plane at which a beam splitting element or beam splitter BS splits the illumination wavefront into an object illumination branch OIB (more generally an object branch) and a reference illumination branch RIB (more generally a reference branch). An object illumination aperture OIA (object illumination numerical aperture NA) in the object illumination branch OIB configures the object illumination pupil, while a corresponding reference illumination aperture RIA (reference illumination numerical aperture NA) (i.e., having a matching illumination profile as the object illumination aperture) in the reference illumination branch RIB configures the reference illumination pupil.

Two example illumination aperture profiles are shown, a first illumination aperture profile IAP1 is a quartered or quad profile (dark regions block the illumination, white regions pass the illumination) which is known and used in many present dark-field imaging techniques, e.g., to provide for simultaneous imaging from two directions. Such an aperture profile provides for partial-incoherent dark-field interferometric microscopy.

A second illumination aperture profile IAP2 is of a type which may provide for full incoherent dark-field interferometric microscopy. It is not the profile itself which configures the arrangement as a fully incoherent system, but rather that the illumination overfills the detection aperture (detection illumination numerical aperture NA). There are a number of ways for achieving this, including using an illumination aperture profile such as that labeled IAP2 with illumination regions (e.g., one per illumination direction as shown) which are larger than corresponding regions of the detection aperture of the system. In such an arrangement, the illumination aperture (and/or detection aperture) may require configuration for a particular pitch-to-wavelength ratio (where pitch is the target pitch and wavelength is the illumination wavelength). More detail of these aperture profiles and illumination modes will be described below. The reference branch aperture may alternatively be a fully open aperture, or else be different from that of the object branch aperture in other embodiments, e.g., where there is no SLM or grating in the reference branch (see below).

The configured illumination is directed e.g., via a non-polarizing beam splitter NPBS, quad mirror or any other suitable optical component and lens or lens system to a target or structure on a wafer W (or more generally an object). The lens used to focus the configured illumination onto the target may be the objective lens OB (e.g., where the illumination is focused on the wafer and the scattered radiation collected by the same objective lens OB as illustrated), or a separate illumination lens (e.g., where the illumination is focused on the wafer using a different lens than an objective lens used to collect the scattered radiation).

The scattered radiation from the wafer W is collected by an objective lens OB. The zeroth order of the scattered radiation is blocked in the object detection branch ODB using a zeroth order block ZB (any filter arrangement which prevents the zeroth order of the scattered radiation from reaching the detector DET may be used). The remaining scattered radiation is combined with the reference radiation in the reference detection branch RDB (or more generally reference branch); e.g., using a beam combining element BC or any other suitable element or arrangement. A wedge arrangement WDG or other optical element or arrangement may be used to ensure each component of the object radiation interferes on the detector DET with a respective component of the reference radiation. This will be described in more detail below. An imaging lens IML may be used to image the resulting interferograms (holograms or interferometric images) on the detector DET.

In an embodiment, the reference branch may comprise a second beam splitter BS2 and an optically inverting element OIE in a field conjugate (e.g., as provided by lens or lens system L2). The optically inverting element OIE may for example be a mirror/reflector or relay device. In other embodiments, the optically inverting element may additionally apply a modulation to the reference radiation, e.g., it may be a spatial light modulator (SLM) or grating (e.g., a phase modulator/grating and/or an amplitude modulator/grating). In this illustration, this arrangement divides the reference branch into what may be considered to be a reference illumination branch RIB and reference detector branch RDB. The optional optically inverting element inverts the point symmetric arrangement of the radiation to mimic the inversion imposed by the wafer in the object branch.

Where this device is an SLM (or grating) it can also be used to control the phase-shift distribution (and optionally also the amplitude distribution) in the interference term of the intensity distribution on the detector DET (e.g., to mimic the behavior of the grating/target being measured). Specifically, it may be arranged to redirect the reference wavefront at the same angle as the target diffraction angle. For parallel acquisition of the +1st and -1st orders, the SLM may be arranged to behave like a grating with e.g., high diffraction efficiency.

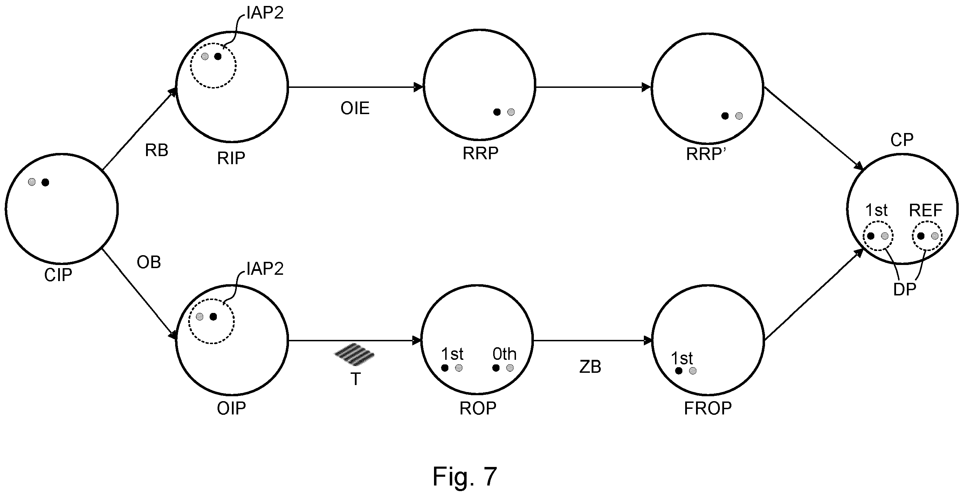

Figure 7 is a flow diagram illustrating various pupils at different planes through the reference branch RB and object branch OB of a metrology tool such as illustrated in Figure 6. A common illumination pupil CIP is shown with two arbitrarily chosen pupil points illustrated, a first pupil point shaded gray and a second pupil point shaded black. The illumination within the common illumination pupil CIP is incoherent and therefore these two pupil points have no known phase relation. This common pupil is split (e.g., by first beamsplitter BS1) into a reference branch RB (top of illustration) and object branch OB (bottom of illustration). In both branches, the illumination aperture is shown, here second illumination aperture IAP2 (aperture for only one direction shown). The reference illumination pupil RIP and object illumination pupil OIP are copies of the common illumination pupil CIP and are therefore also each spatially incoherent, but pointwise mutually coherent, since they originated from a unique wavefront. As such, the gray shaded pupil point of the object illumination pupil OIP is spatially coherent with the the gray shaded pupil point of the reference illumination pupil RIP, and similarly the black shaded pupil point of the object illumination pupil OIP is spatially coherent with the the black shaded pupil point of the reference illumination pupil RIP.

In the object branch OB, the illumination is focused onto a target T and the scattered radiation captured. As such, the reflected object pupil ROP comprises the scattered/reflected radiation from the target is shown, this comprising a 1st order (one of the +1 order or -1 order is shown; embodiments may simultaneously capture both of these orders) and a zeroth order. The zeroth order is then blocked (e.g., using a zero order block ZB) to provide a filtered reflected object pupil FROP comprising only one or more higher orders (here a 1st order).

In the reference branch RB, the reference radiation is (optionally) reflected (and optionally modulated) by an optically inverting element OIE to mimic the effect of the target/wafer in the object branch. The reflected reference pupil RRP (the prime RRP' simply represents the pupil propagating through the reference branch, there is no zeroth order to block here) and filtered reflected object pupil FROP are combined into a combined pupil CP. An exemplary detection pupil DP is shown, this being slightly smaller in area than the illumination pupil aperture IAP2, to obtain a fully coherent system according to an embodiment. This combined pupil CP can be focused onto a detector or camera such that the reference radiation REF and object radiation 1st interfere to provide an interference image or interferogram.

When finally imaged by an additional lens (e.g., imaging lens IML) onto the camera, the object radiation and reference radiation will interfere on a per-point basis. As such, at each pupil illustrated, the gray pupil point in the object branch is spatially coherent with the gray pupil point in the reference branch and the black pupil point in the object branch is spatially coherent with the black pupil point in the reference branch (similarly with all corresponding points in each branch). The result of this is that the imaged interferogram is an incoherent combination (sum) of many coherent (pointwise coherent) interferograms, each corresponding to pairs of pupil points in the reference branch and object branch.

The system disclosed herein supports any level of spatial coherence (fully coherent, partially coherent and fully incoherent via proper pupil shaping), as well as any level of temporal coherence (from (quasi-) monochromatic to very broadband white light). For example, the system may be realized as a partially-incoherent system or fully (or near fully) coherent system. This may be dependent on the illumination and detection apertures used. The first illumination aperture profile IAP1 or quad profile, for example, may be used to realize a partially coherent system.

If the illumination aperture is sufficiently larger than the aperture in the detection branch, then the diffracted near-field of the target is effectively incoherent. The second illumination aperture profile IAP2 is an example illumination aperture which may be used in combination with a detection aperture profile having a smaller area to realize an incoherent system. For example, an illuminator pupil may be used that is only slightly larger than the detection pupil aperture such that 1st order diffraction from the overlay target overfills the detection pupil aperture. In an embodiment, for example, the overlapping/alignment of the +1 and -1 orders may be such that the whole of the orders overlap the detection NA. In other embodiments, it may be at least 95%, at least 90%, at least 80% or at least 70 % of the +1 and -1 orders overlap the detection NA.

To achieve this, the centers of the illumination pupil and detection pupil aperture in pupil space should be $\frac{\lambda}{p}$. This may be achieved with a programmable or configurable illuminator, keeping the detection pupil apertures fixed (or *vice versa,* or having both apertures configurable), which can be configured based on wavelength and/or target pitch. For example, a configurable illuminator or configurable illumination numerical aperture profile which is configurable for a measurement based on the detection numerical aperture profile and a ratio of said pitch and said wavelength such that at least a pair of complementary diffraction orders are captured within the detection numerical aperture profile. The configurability of the illumination pupil profile can be achieved by selection of a particular spatial filter as appropriate. Filters may be manually inserted or mounted to a filter wheel for example. Other filtering options include providing a spatial light modulator SLM in place of spatial filter SF, or even providing a spatially configurable light source for which its illumination profile can be directly configured. Any such method or any other method for obtaining and/or configuring a desired illumination profile may be used. Alternatively (or in addition) to a configurable illumination profile, a configurable substrate orientation may be provided for the same effect.

As mentioned above, it should be arranged that the correct parts of the object illumination interfere with corresponding parts of the reference radiation (i.e., the corresponding regions in pupil space comprising the corresponding points having pointwise coherence). There are a number of methods/arrangements for achieving this. For example, wedges or any optical arrangement (e.g., any one or more suitable radiation directing elements) for directing each object radiation component/order to interfere with a respective reference radiation component may be used. It is also possible to arrange objectreference component pairs in the pupil such that they interfere without radiation directing elements. As such, the metrology device may comprise a plurality of radiation directing elements to ensure the correct components interfere. The radiation directing elements may be comprised within a single compound or monolithic object/optical element, or as two or more discrete object/optical elements (e.g., one discrete optical element per component or otherwise).

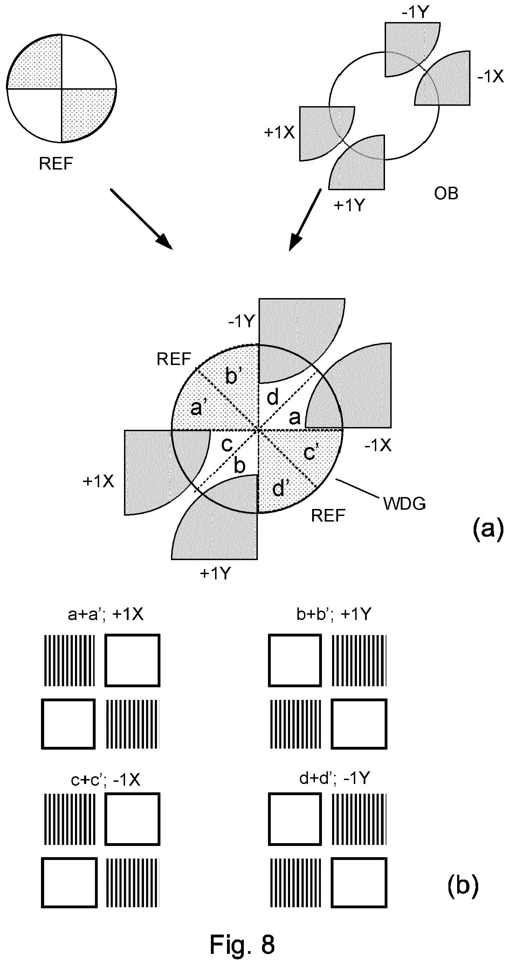

Figure 8(a) illustrates an exemplary wedge embodiment for ensuring the desired components interfere at the detector. This Figure is shown in relation to the quad aperture OAP1, but is generally applicable. In this embodiment, the metrology tool is configured for simultaneous imaging of two diffraction orders (e.g., complementary diffraction orders such as a +1 order and a -1 order) for two target directions (i.e., two orthogonal directions of periodicity in a substrate plane, here designated as an X direction and Y direction). Because of this, there are four components of interest in the object radiation and four corresponding components of the reference radiation. To accommodate this, an 8-fold wedge is proposed, having a directing element or directing portion for each of these eight components. Of course, a 4-fold wedge (or more generally four directing portions/elements) may be appropriate where there are two components of interest in the object radiation (e.g., detection of two orders in a single direction or single order in two directions).

A reference wavefront REF in detection pupil and object wavefront OB in detection pupil (zeroth order blocked) is overlapped on a wedge element WDG. The object wavefront OB may comprise four components of interest, +1 diffraction order from X-target +1X, -1 diffraction order from X-target -IX, +1 diffraction order from Y-target +1Y and -1 diffraction order from Y-target -1Y. The reference wavefront radiation REF occupies the pupil space normally occupied by the blocked zeroth order.

The wedge element WDG comprises eight sections or directing regions labeled a, a', b, b', c, c', d, d'. This labeling identifies pairs of directing regions (each pair labeled with the same letter, one with a prime), each pair of directing regions being oriented to direct respective radiation components incident thereon to interfere with each other. As such, the directing region a directs its radiation component to interfere with the radiation component corresponding to directing region a' and *vice versa.* Each of the directing regions labeled with a prime correspond to pupil space occupied by the reference radiation and the directing regions labeled without a prime correspond to pupil space occupied by the object radiation.

Figure 8(b) illustrates the images or incoherent interferograms of a target (here, purely as an example, comprising four sub-targets, two for the X direction and two for the Y direction) as might be detected on a detector resultant from the arrangement shown in Figure 8(a). They comprise a first image a+a' resultant from the directing regions a, a' and corresponding to +1 diffraction order from X-target +1X interfered with a first respective portion of the reference radiation, a second image b+b' resultant from the directing regions b, b' and corresponding to +1 diffraction order from Y-target +1Y interfered with a second respective portion of the reference radiation, a third image c+c' resultant from the directing regions c, c' and corresponding to -1 diffraction order from X-target -IX interfered with a third respective portion of the reference radiation and a fourth image d+d' resultant from the directing regions d, d' and corresponding to -1 diffraction order from Y-target -1Y interfered with a fourth respective portion of the reference radiation. By imaging X and Y pads separately in this manner, the amount of cross-talk is reduced.

It should be appreciated that the reference branch pupil and object branch pupil are merely spatially overlapped in the common pupil plane where the wedge is located; they do not interfere at this plane, only at the detector.

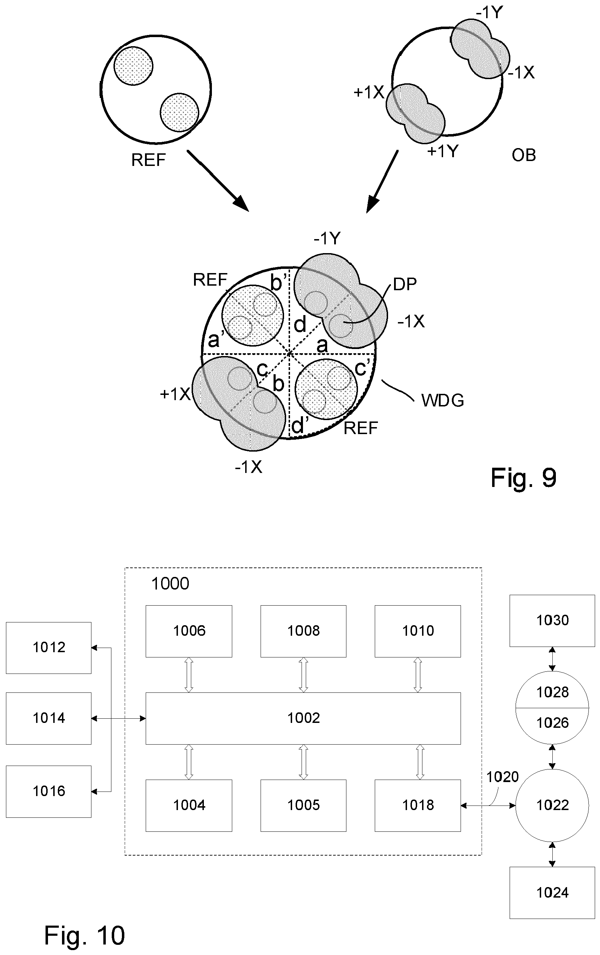

Figure 9 shows the same arrangement as Figure 8(a) for reference REF and object OB wavefronts corresponding to a fully coherent imaging mode (e.g., corresponding to input apertures IAP2). The detection pupil is represented by circles DP (only one labeled), one per component of the object and reference radiation. Otherwise, the arrangement is otherwise the same and will result in essentially similar images (visually) on the detector as those illustrated in Figure 8(b).

A main advantage of the system (at least when operated in a fully coherent configuration) is that complex reflectivity (and therefore phase reflectivity) can be determined/reconstructed from the image. It should be appreciated that this is an incoherent system so there is no concept of phase of the radiation in either branch. As such, the phase of wavefront is not accessible as it does not exist for spatially incoherent light, but the phase of complex reflectivity of the target is accessible. Measurement of the complex reflectivity of the target potentially improves overlay accuracy and robustness by adding an additional channel of information about the target: phase of its complex reflectivity.

In an embodiment, the observed intensity distribution (or a parameter distribution of a related parameter) on the detector can be deconvolved with the incoherent point spread function (PSF) of the detection branch to obtain pure intensity. This pure intensity may be further demodulated to separate out the interference cross-term, and potentially, the complex reflectivity of the target.

The intensity distribution $I_c(x)$ on the detector from interference of a 1st order (e.g., +1) and reference light (target hologram) is described for a single point source in the common pupil by:

$$I_c(x) = |E_c(x)|^2 = \left|E_0 M + E_0 R e^{iKx}\right|^2 = I_0(|M|^2 + |R|^2 + RM^* e^{iKx} + R^* M e^{-iKx})$$

where: $E_0$ is the source complex amplitude, $M$ is the (known) amplitude transmission of the reference branch, $Re^{iKx}$ ($R$ is unknown, $K = 2\pi/p$ is known) is the amplitude reflectance of the target in the 1st order and $E_c(x) = E_0 M + E_0 R e^{iKx}$ is the sum of the reference and sensing fields on the camera.

Fourier transform of the intensity distribution $I_c(x)$ yields central band (background intensity) and two sidebands proportional to complex reflectivity.

The intensity distribution on the detector for incoherent imaging comprises the sum of many incoherent convolutions. Point spread functions account for illumination and imaging optics (e.g., aberrations, apertures, etc.), and are assumed to be known. Assuming the incoherent imaging conditions are satisfied (illumination aperture sufficiently overfills the detection aperture), the intensity distribution $I_c(x,y)$ is described by:

$$I_c(x,y) = \frac{1}{4} \iint \left\{ \left| \hat{P}_{r,d}(x,x',y,y') \right|^2 I_0(x',y') \left| M(x',y') \right|^2 + \left| \hat{P}_{s,d}(x,x',y,y') \right|^2 I_0(x',y') |R_{\pm 1}|^2 \, \Pi(x',y') + \right.$$
$$+ \hat{P}_{s,d}(x,x',y,y') \hat{P}^*_{r,d}(x,x',y,y') I_0(x',y') R_{\pm 1} e^{\pm iKx'} \Pi(x',y') M^*(x',y') e^{i\varphi(x',y')} +$$
$$\left. + \hat{P}^*_{s,d}(x,x',y,y') \hat{P}_{r,d}(x,x',y,y') I_0(x',y') R^*_{\pm 1} e^{\mp iKx'} \Pi(x',y') M(x',y') e^{-i\varphi(x',y')} \right\} dx'dy'.$$

In this case, Fourier transformation of the intensity distribution (demodulation) yields central band (background intensity) and two sidebands proportional to complex reflectivity $R_{\pm} e^{\pm iKx'}$ (or $R^*_{\pm} e^{\mp iKx'}$). These sidebands can be isolated and deconvolved with known kernels to deconvolve out the point spread functions, e.g., to perform aberration correction and/or to reconstruct the target's complex reflectivity. For example, with the complex reflectivity reconstructed, overlay can be determined directly from the phase of this complex reflectivity. The method for doing this is essentially the same as the methods for determining overlay direct from phase described in WO2019/166190, which is hereby incorporated by reference.

WO2019/166190 describes a method for measuring overlay relating to a target on a substrate comprising determining an overlay induced phase change contribution of the scattered radiation, overlay induced phase change contribution comprising the effect of overlay on the phase of the illuminating radiation when scattered by said target; and calculating the value for overlay directly from the determined overlay induced phase change contribution. The overlay induced phase change contribution may be determined from reflectivity intensity and reflectivity phase relating to each diffraction order of a corresponding higher order pair of diffraction orders (e.g., +1 and -1 orders) comprised within the radiation scattered by the target. The target may comprise at least a first sub-target with a first known overlay bias, and a second sub-target with either no overlay bias or a second known overlay bias different from the first known overlay bias, such that the overlay induced phase change contribution is determined from comparisons of said diffraction orders comprised in said scattered radiation from each of the first sub-target and second sub-target. For example, the overlay induced phase change contribution may be determined from a first relative phase of: a first positive higher order diffracted field relating to the first sub-target and a second positive higher order diffracted field relating to the second sub-target; and a second relative phase of: a first negative higher order diffracted field relating to the first sub-target and a second negative higher order diffracted field relating to the second sub-target. The overlay induced phase change contribution may be further determined from: a third relative phase of: the first positive higher order diffracted field and the second negative higher order diffracted field; and a fourth relative phase of: the first negative higher order diffracted field and the second positive higher order diffracted field.

For the partially incoherent imaging configuration, the intensity distribution is described by:

$$I_c(x,y) = J_c(x,y,x,y) =$$
$$= \frac{1}{2} \iint \iint \hat{P}_{r,d}(x,x',y,y') \hat{P}^*_{r,d}(x,x'',y,y'') M(x',y') M^*(x'',y'') \langle \tilde{u}_2(x',y') \tilde{u}^*_2(x'',y'') \rangle \, dx'dy'dx''dy'' +$$
$$+ \frac{1}{2} \iint \iint \hat{P}_{s,d}(x,x',y,y') \hat{P}^*_{s,d}(x,x'',y,y'') |R_{\pm 1}|^2 \, e^{\pm iK(x'-x'')} \Pi(x',y') \Pi(x'',y'') \langle \tilde{u}_1(x',y') \tilde{u}^*_1(x'',y'') \rangle \, dx'dy'dx''dy''$$
$$+ \frac{1}{2} \iint \iint \hat{P}_{s,d}(x,x',y,y') \hat{P}^*_{r,d}(x,x'',y,y'') R_{\pm 1} e^{\pm iKx'} \Pi(x',y') M^*(x'',y'') \langle \tilde{u}_1(x',y') \tilde{u}^*_2(x'',y'') \rangle \, dx'dy'dx''dy'' +$$
$$+ \frac{1}{2} \iint \iint \hat{P}_{r,d}(x,x',y,y') \hat{P}^*_{s,d}(x,x'',y,y'') R^*_{\pm 1} e^{\mp iKx''} \Pi(x'',y'') M(x',y') \langle \tilde{u}^*_1(x'',y'') \tilde{u}_2(x',y') \rangle \, dx'dy'dx''dy''.$$

In this example, it is not possible, or it is at least difficult, to deconvolve out the PSF. Instead overlay can be determined from the intensity using standard techniques. While phase information may not be available, the advantage of "noiseless" amplification from application of the reference radiation is still obtained, which increases the signal-to-noise ratio with respect to technical noise (e.g., camera noise etc.), but not shot noise (i.e., the gain is shot noise limited).

If the demodulation of the sidebands is not feasible in the partially-incoherent DHM example, but noiseless signal amplification is still desired, e.g. for dark layers, then the interferometer device described herein may be provided with two imaging branches having respective cameras. This enables a differential image to be generated from the images captured by the two respective cameras, meaning that the background intensity may be removed, isolating the interference cross-terms.

In summary, the disclosed herein is an incoherent (or partial-incoherent) dark-field interferometric microscope which enables computational aberration correction and removal/reduction of incoherent crosstalk, improving machine-to-machine matching. The measured signal is amplified "noiselessly", improving detectability of dark layers. Furthermore, the complex reflectivity of the target can be reconstructed, potentially improving overlay accuracy.

While the above examples are described in terms of a metrology tool for measuring overlay and more generally in terms of monitoring lithographic processes in manufacture of integrated circuits, the concepts disclosed herein are not so limited. The metrology tool disclosed herein may be used to measure any characteristic of interest of a structure such as a target, such as focus, dose, critical dimension and EPE (Edge Placement Error), which is a more complex form of overlay (e.g., a combination of overlay and critical dimension uniformity). The metrology tool disclosed herein may be equally used to measure other samples or objects in contexts separate from lithography and IC manufacture.

Figure 10 is a block diagram that illustrates a computer system 1000 that may assist in implementing the methods and flows disclosed herein. Computer system 1000 includes a bus 1002 or other communication mechanism for communicating information, and a processor 1004 (or multiple processors 1004 and 1005) coupled with bus 1002 for processing information. Computer system 1000 also includes a main memory 1006, such as a random access memory (RAM) or other dynamic storage device, coupled to bus 1002 for storing information and instructions to be executed by processor 1004. Main memory 1006 also may be used for storing temporary variables or other intermediate information during execution of instructions to be executed by processor 1004. Computer system 1000 further includes a read only memory (ROM) 1008 or other static storage device coupled to bus 1002 for storing static information and instructions for processor 1004. A storage device 1010, such as a magnetic disk or optical disk, is provided and coupled to bus 1002 for storing information and instructions.

Computer system 1000 may be coupled via bus 1002 to a display 1012, such as a cathode ray tube (CRT) or flat panel or touch panel display for displaying information to a computer user. An input device 1014, including alphanumeric and other keys, is coupled to bus 1002 for communicating information and command selections to processor 1004. Another type of user input device is cursor control 1016, such as a mouse, a trackball, or cursor direction keys for communicating direction information and command selections to processor 1004 and for controlling cursor movement on display 1012. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1000 in response to processor 1004 executing one or more sequences of one or more instructions contained in main memory 1006. Such instructions may be read into main memory 1006 from another computer-readable medium, such as storage device 1010. Execution of the sequences of instructions contained in main memory 1006 causes processor 1004 to perform the process steps described herein. One or more processors in a multi-processing arrangement may also be employed to execute the sequences of instructions contained in main memory 1006. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1004 for execution. Such a medium may take many forms, including but not limited to, non-volatile media, volatile media, and transmission media. Non-volatile media include, for example, optical or magnetic disks, such as storage device 1010. Volatile media include dynamic memory, such as main memory 1006. Transmission media include coaxial cables, copper wire and fiber optics, including the wires that comprise bus 1002. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1004 for execution. For example, the instructions may initially be borne on a magnetic disk of a remote computer. The remote computer can load the instructions into its dynamic memory and send the instructions over a telephone line using a modem. A modem local to computer system 1000 can receive the data on the telephone line and use an infrared transmitter to convert the data to an infrared signal. An infrared detector coupled to bus 1002 can receive the data carried in the infrared signal and place the data on bus 1002. Bus 1002 carries the data to main memory 1006, from which processor 1004 retrieves and executes the instructions. The instructions received by main memory 1006 may optionally be stored on storage device 1010 either before or after execution by processor 1004.

Computer system 1000 also preferably includes a communication interface 1018 coupled to bus 1002. Communication interface 1018 provides a two-way data communication coupling to a network link 1020 that is connected to a local network 1022. For example, communication interface 1018 may be an integrated services digital network (ISDN) card or a modem to provide a data communication connection to a corresponding type of telephone line. As another example, communication interface 1018 may be a local area network (LAN) card to provide a data communication connection to a compatible LAN. Wireless links may also be implemented. In any such implementation, communication interface 1018 sends and receives electrical, electromagnetic or optical signals that carry digital data streams representing various types of information.

Network link 1020 typically provides data communication through one or more networks to other data devices. For example, network link 1020 may provide a connection through local network 1022 to a host computer 1024 or to data equipment operated by an Internet Service Provider (ISP) 1026. ISP 1026 in turn provides data communication services through the worldwide packet data communication network, now commonly referred to as the "Internet" 1028. Local network 1022 and Internet 1028 both use electrical, electromagnetic or optical signals that carry digital data streams. The signals through the various networks and the signals on network link 1020 and through communication interface 1018, which carry the digital data to and from computer system 1000, are exemplary forms of carrier waves transporting the information.

Computer system 1000 may send messages and receive data, including program code, through the network(s), network link 1020, and communication interface 1018. In the Internet example, a server 1030 might transmit a requested code for an application program through Internet 1028, ISP 1026, local network 1022 and communication interface 1018. One such downloaded application may provide for one or more of the techniques described herein, for example. The received code may be executed by processor 1004 as it is received, and/or stored in storage device 1010, or other non-volatile storage for later execution. In this manner, computer system 1000 may obtain application code in the form of a carrier wave.

Further embodiments are disclosed in the subsequent list of numbered clauses:

1. A dark-field interferometric microscope comprising:

an object branch being operable to propagate object radiation onto a sample and collect resultant scattered radiation from said sample;
a reference branch being operable to propagate reference radiation;
a filter arrangement operable to remove a zeroth order component from said scattered radiation to provide filtered scattered radiation; and
a detection arrangement operable to detect an interferometric image from interference of said filtered scattered radiation and reference radiation;
wherein said object radiation and said reference radiation are mutually pointwise spatially coherent.

2. A dark-field interferometric microscope as defined in clause 1, comprising a beam splitting element in a pupil plane or conjugate thereof, being operable to receive an input beam comprising incoherent radiation and divide said input beam of incoherent radiation into said object radiation and said reference radiation, to provide object radiation and reference radiation which are copies of each other.

3. A dark-field interferometric microscope as defined in clause 1 or 2, wherein pointwise spatial coherence describes mutual spatial coherence between pairs of pupil points, each pair of pupil points comprising a corresponding pupil point respectively in each of said object radiation and reference radiation, but where the pupil points of each of said object radiation and said reference radiation are incoherent.

4. A dark-field interferometric microscope as defined in clause 3, operable such that said interferometric image is formed from an incoherent combination of a plurality of interferometric image respectively generated from interference of said pair of pupil points.

5. A dark-field interferometric microscope as defined in any preceding clause, wherein said reference branch comprises an optically inverting element in a field conjugate, said optically inverting element being operable to invert the point symmetric arrangement of the reference radiation.

6. A dark-field interferometric microscope as defined in clause 5, wherein said optically inverting element is a lens relay or mirror.

7. A dark-field interferometric microscope as defined in clause 5, wherein said optically inverting element is a grating or spatial light modulator.

8. A dark-field interferometric microscope as defined in clause 7, wherein said grating or spatial light modulator is at least a phase grating or phase spatial light modulator.

9. A dark-field interferometric microscope as defined in any preceding clause, comprising a beam combining element operable to combine said reference radiation and said filtered scattered radiation such that they overlap in a pupil plane or conjugate thereof.

10. A dark-field interferometric microscope as defined in any preceding clause, operable such that said reference radiation is accommodated in portion of a detection numerical aperture corresponding to the filtered out zeroth order component.

11. A dark-field interferometric microscope as defined in any preceding clause, comprising an optical arrangement operable to direct a plurality of object radiation components comprised within said filtered scattered radiation and respective reference radiation components of said reference radiation such that each of said object radiation components interferes with a respective corresponding reference radiation component.

12. A dark-field interferometric microscope as defined in clause 11, wherein each object radiation component comprises a different diffraction order.

13. A dark-field interferometric microscope as defined in clause 11 or 12, wherein said plurality of object radiation components comprises at least four object radiation components.

14. A dark-field interferometric microscope as defined in any of clauses 11 to 13, being operable such that said interferometric image comprises separated sub-images corresponding to each of said object radiation components.

15. A dark-field interferometric microscope as defined in any of clauses 11 to 14, wherein said optical arrangement comprises one or more radiation directing elements.

16. A dark-field interferometric microscope as defined in clause 15, wherein said radiation directing elements are comprised as an optical wedge arrangement having a respective directing element for each of said object radiation components and each of said reference radiation components.

17. A dark-field interferometric microscope as defined in any preceding clause, comprising a detection arrangement having a lens or lens arrangement and at least one detector for detecting said interferometric image.

18. A dark-field interferometric microscope as defined in any preceding clause, comprising an object illumination numerical aperture in the object branch and a detection numerical aperture, and wherein the object illumination numerical aperture is larger than the detection numerical aperture, such that said detection numerical aperture is filled with said filtered scattered illumination.

19. A dark-field interferometric microscope as defined in clause 18, wherein said reference branch comprises a reference illumination numerical aperture similar to said object illumination numerical aperture.

20. A dark-field interferometric microscope as defined in clause 18 or 19, comprising a configurable illumination numerical aperture profile and/or substrate orientation which is configurable for a measurement based on the detection numerical aperture and a ratio of a pitch of the sample and a wavelength of the object radiation such that desired components of said filtered scattered radiation are captured within the detection numerical aperture.

21. A dark-field interferometric microscope as defined in any preceding clause, comprising a processor operable to: determine a complex reflectivity of said sample from said interferometric image.

22. A dark-field interferometric microscope as defined in clause 21, wherein said interferometric image comprises a parameter distribution; and said processor is operable to:
deconvolve an incoherent point spread function from said parameter distribution to determine said complex reflectivity of the sample.

23. A dark-field interferometric microscope as defined in clause 21 or 22, wherein said processor is further operable to determine a phase of said complex reflectivity of the sample and determine a parameter of interest from at least said phase.

24. A dark-field interferometric microscope as defined in any of clauses 21 to 23, wherein said processor is further operable to perform aberration correction by deconvolving one or more kernels relating to aberrations of one or more elements within said dark-field interferometric microscope.

25. A dark-field interferometric microscope as defined in any preceding clause, comprising a substrate stage for holding a substrate comprising structures formed by a lithographic process.

26. A method of performing dark-field interferometric microscopy comprising:

propagating object radiation onto a sample and collect resultant scattered radiation from said sample;
removing a zeroth order component from said scattered radiation to provide filtered scattered radiation;
propagating reference radiation;
detecting an interferometric image from interference of said filtered scattered radiation and reference radiation;
wherein said object radiation and said reference radiation are mutually pointwise spatially coherent.

27. A method as defined in clause 26, comprising receiving an input beam comprising incoherent radiation and dividing, in a pupil plane or conjugate thereof, said input beam of incoherent radiation into said object radiation and said reference radiation, to provide incoherent object radiation and incoherent reference radiation which are copies of each other.

28. A method as defined in clause 26 or 27, wherein pointwise spatial coherence describes mutual spatial coherence between pairs of pupil points, each pair of pupil points comprising a corresponding pupil point respectively in each of said object radiation and reference radiation, but where the pupil points of each of said object radiation and said reference radiation are incoherent.

29. A method as defined in clause 28, wherein said interferometric image is formed from an incoherent combination of a plurality of interferometric image respectively generated from interference of said pair of pupil points.

30. A method as defined in any of clauses 26 to 30, comprising inverting the point symmetric arrangement of the reference radiation.

31. A method as defined in any of clauses 26 to 30, comprising spatially modulating said reference radiation.

32. A method as defined in clause 31, wherein said spatially modulating comprises modulating a phase-shift distribution and/or amplitude distribution in an interference term of an parameter distribution of said interferometric image.

33. A method as defined in any of clauses 26 to 32, comprising combining said reference radiation and said filtered scattered radiation such that they overlap in a pupil plane or conjugate thereof.

34. A method as defined in any of clauses 26 to 33, comprising accommodating said reference radiation in portion of a detection numerical aperture corresponding to the filtered out zeroth order component.

35. A method as defined in any of clauses 26 to 34, comprising directing a plurality of object radiation components comprised within said filtered scattered radiation and respective reference radiation components of said reference radiation such that each of said object radiation components interferes with a respective corresponding reference radiation component.

36. A method as defined in clause 35, wherein each object radiation component comprises a different diffraction order.

37. A method as defined in clause 35 or 36, wherein said plurality of object radiation components comprises at least four object radiation components.

38. A method as defined in any of clauses 35 to 37, comprising imaging said interferometric image as separated sub-images corresponding to each of said object radiation components.

39. A method as defined in any of clauses 26 to 38, comprising filling a detection numerical aperture with said filtered scattered illumination.

40. A method as defined in clause 39, comprising configuring an illumination numerical aperture profile and/or substrate orientation for a measurement based on the detection numerical aperture and a ratio of a pitch of the sample and a wavelength of the object radiation such that desired components of said filtered scattered radiation are captured within the detection numerical aperture.

41. A method as defined in any of clauses 26 to 40, comprising determining a complex reflectivity of said sample from said interferometric image.

42. A method as defined in clause 41, comprising deconvolving an incoherent point spread function from a parameter distribution of said interferometric image to determine said complex reflectivity of the sample.

43. A method as defined in clause 41 or 42, comprising determining a phase of said complex reflectivity of the sample and determining a parameter of interest from at least said phase.

44. A method as defined in any of clauses 26 to 43, comprising performing aberration correction by deconvolving one or more kernels relating to aberrations of one or more optical elements used to perform said method.

45. A method as defined in any of clauses 26 to 44, wherein said sample comprises a structure formed by a lithographic process on a substrate.

46. A metrology apparatus for determining a characteristic of interest of a structure on a substrate, the metrology apparatus comprising the dark-field interferometric microscope according to any one of the clauses 1 to 25.

47. A lithographic cell comprising the dark-field interferometric microscope according to any one of the clauses 1 to 25 or the metrology apparatus according to clause 46.

48. A lithographic apparatus comprising the dark-field interferometric microscope according to any one of the clauses 1 to 25

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1.  A dark-field interferometric microscope comprising:

    an object branch being operable to propagate object radiation onto a sample and collect resultant scattered radiation from said sample;
    a reference branch being operable to propagate reference radiation;
    a filter arrangement operable to remove a zeroth order component from said scattered radiation to provide filtered scattered radiation; and
    a detection arrangement operable to detect an interferometric image from interference of said filtered scattered radiation and reference radiation;
    wherein said object radiation and said reference radiation are mutually pointwise spatially coherent.

2.  A dark-field interferometric microscope as claimed in claim 1, comprising a beam splitting element in a pupil plane or conjugate thereof, being operable to receive an input beam comprising incoherent radiation and divide said input beam of incoherent radiation into said object radiation and said reference radiation, to provide object radiation and reference radiation which are copies of each other.

3.  A dark-field interferometric microscope as claimed in claim 1 or 2, wherein pointwise spatial coherence describes mutual spatial coherence between pairs of pupil points, each pair of pupil points comprising a corresponding pupil point respectively in each of said object radiation and reference radiation, but where the pupil points of each of said object radiation and said reference radiation are incoherent.

4.  A dark-field interferometric microscope as claimed in claim 3, operable such that said interferometric image is formed from an incoherent combination of a plurality of interferometric image respectively generated from interference of said pair of pupil points.

5.  A dark-field interferometric microscope as claimed in any preceding claim, wherein said reference branch comprises an optically inverting element in a field conjugate, said optically inverting element being operable to invert the point symmetric arrangement of the reference radiation.

6.  A dark-field interferometric microscope as claimed in any preceding claim, comprising a beam combining element operable to combine said reference radiation and said filtered scattered radiation such that they overlap in a pupil plane or conjugate thereof.

7. A dark-field interferometric microscope as claimed in any preceding claim, operable such that said reference radiation is accommodated in portion of a detection numerical aperture corresponding to the filtered out zeroth order component.

8. A dark-field interferometric microscope as claimed in any preceding claim, comprising an optical arrangement operable to direct a plurality of object radiation components comprised within said filtered scattered radiation and respective reference radiation components of said reference radiation such that each of said object radiation components interferes with a respective corresponding reference radiation component.

9. A dark-field interferometric microscope as claimed in claim 8, wherein each object radiation component comprises a different diffraction order.

10. A dark-field interferometric microscope as claimed in any preceding claim, comprising an object illumination numerical aperture in the object branch and a detection numerical aperture, and wherein the object illumination numerical aperture is larger than the detection numerical aperture, such that said detection numerical aperture is filled with said filtered scattered illumination.

11. A dark-field interferometric microscope as claimed in claim 10, wherein said reference branch comprises a reference illumination numerical aperture similar to said object illumination numerical aperture.

12. A dark-field interferometric microscope as claimed in claim 10 or 11, comprising a configurable illumination numerical aperture profile and/or substrate orientation which is configurable for a measurement based on the detection numerical aperture and a ratio of a pitch of the sample and a wavelength of the object radiation such that desired components of said filtered scattered radiation are captured within the detection numerical aperture.

13. A method of performing dark-field interferometric microscopy comprising:

propagating object radiation onto a sample and collect resultant scattered radiation from said sample;
removing a zeroth order component from said scattered radiation to provide filtered scattered radiation;
propagating reference radiation;
detecting an interferometric image from interference of said filtered scattered radiation and reference radiation;
wherein said object radiation and said reference radiation are mutually pointwise spatially coherent.

14. A metrology apparatus for determining a characteristic of interest of a structure on a substrate, the metrology apparatus comprising the dark-field interferometric microscope according to any one of the claims 1 to 12.

15. A lithographic cell comprising he dark-field interferometric microscope according to any one of the claims 1 to 12 or the metrology apparatus according to claim 14..

Fig. 1

Fig. 2

Fig. 3

Fig. 4

Fig. 5

Fig. 6

Fig. 7

EP 4 124 909 A1

-1Y

-1X

+1X

+1Y

OB

REF

-1Y

REF

b'

a'

d

a

c

c'

b

d'

-1X

+1X

REF

WDG

+1Y

(a)

a+a'; +1X

b+b'; +1Y

c+c'; -1X

d+d'; -1Y

(b)

Fig. 8

Fig. 9

Fig. 10

Europäisches
Patentamt

European
Patent Office

Office européen
des brevets

# EUROPEAN SEARCH REPORT

Application Number

EP 21 18 8279

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2019/197117 A1 (STICHTING VU [NL] ET AL.) 17 October 2019 (2019-10-17) | 1,3,4,6, 8,9, 13-15 | INV. G03F7/20 G01N21/95 |
| A | * abstract * <br> * figure 3 * <br> * paragraphs [0002], [0037] - [0045], [0076], [0097] * | 2,5,7, 10-12 | G02B21/10 G03H1/08 |
| X | WO 2021/121733 A1 (ASML NETHERLANDS BV [NL]; STICHTING VU [NL] ET AL.) 24 June 2021 (2021-06-24) | 1,13-15 | |
| A | * abstract * <br> * figures 1,9,10 * <br> * paragraphs [0002], [0008], [0015] - [0024], [0064], [0065], [0071], [0075] - [0078] * | 2-12 | |
| A | US 2011/141273 A1 (DUBOIS FRANK [BE]) 16 June 2011 (2011-06-16) <br> * abstract * <br> * figure 1 * <br> * paragraphs [0002], [0041] * | 1-15 | |

| | |
|---|---|
| TECHNICAL FIELDS SEARCHED (IPC) | |
| G03F G03H G01N G02B | |

The present search report has been drawn up for all claims

| Place of search | Date of completion of the search | Examiner |
|---|---|---|
| Munich | 11 January 2022 | Andersen, Ole |

EPO FORM 1503 03.82 (P04C01)

## ANNEX TO THE EUROPEAN SEARCH REPORT
## ON EUROPEAN PATENT APPLICATION NO.

EP 21 18 8279

This annex lists the patent family members relating to the patent documents cited in the above-mentioned European search report.
The members are as contained in the European Patent Office EDP file on
The European Patent Office is in no way liable for these particulars which are merely given for the purpose of information.

11-01-2022

| Patent document cited in search report | | Publication date | Patent family member(s) | | Publication date |
|---|---|---|---|---|---|
| WO 2019197117 | A1 | 17-10-2019 | CN | 112204473 A | 08-01-2021 |
| | | | JP | 2021520518 A | 19-08-2021 |
| | | | KR | 20210018212 A | 17-02-2021 |
| | | | NL | 2021848 A | 06-11-2018 |
| | | | TW | 202004356 A | 16-01-2020 |
| | | | TW | 202125121 A | 01-07-2021 |
| | | | US | 2019310559 A1 | 10-10-2019 |
| | | | US | 2021349403 A1 | 11-11-2021 |
| | | | WO | 2019197117 A1 | 17-10-2019 |
| WO 2021121733 | A1 | 24-06-2021 | TW | 202129430 A | 01-08-2021 |
| | | | WO | 2021121733 A1 | 24-06-2021 |
| US 2011141273 | A1 | 16-06-2011 | CA | 2739017 A1 | 08-04-2010 |
| | | | EP | 2329324 A1 | 08-06-2011 |
| | | | ES | 2460869 T3 | 14-05-2014 |
| | | | JP | 5394494 B2 | 22-01-2014 |
| | | | JP | 2012504780 A | 23-02-2012 |
| | | | US | 2011141273 A1 | 16-06-2011 |
| | | | WO | 2010037861 A1 | 08-04-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019197117 A1
- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A
- WO 2019166190 A